# EUROPEAN PATENT SPECIFICATION

(11) **EP 3 357 987 B1**
(45) Date of publication and mention of the grant of the patent: **17.02.2021**
(21) Application number: 16851387.7
(22) Date of filing: 26.09.2016
(51) Int. Cl.: B32B 27/00, B32B 27/28, B32B 27/32, C09J 123/08, C09J 123/26, C09J 151/00, H01L 31/042, B29K 23/00, B29L 7/00, B29L 9/00, B32B 27/30, B32B 27/34, B32B 27/36

(54) **INSULATING MULTILAYER SHEET AND SOLAR CELL MODULE**
ISOLIERENDE MEHRSCHICHTFOLIE UND SOLARZELLENMODUL
FEUILLE MULTICOUCHE ISOLANTE ET MODULE DE CELLULE SOLAIRE

(30) Priority: 30.09.2015 JP 2015193264
(43) Date of publication of application: 08.08.2018
(73) Proprietor: DOW-MITSUI POLYCHEMICALS CO., LTD., Tokyo 1057122 (JP)
(72) Inventor: ISOKAWA Motoaki, Ichihara-shi Chiba 299-0108 (JP); ENDO Yui, Minato-ku, Tokyo 1057122 (JP); SATO Norihiko, Ichihara-shi Chiba 299-0108 (JP); ICHINOSEKI Chikara, Ichihara-shi Chiba 299-0108 (JP); NAKATA Kazuyuki, Ichihara-shi Chiba 299-0108 (JP)
(74) Representative: Gulde & Partner
(86) International application number: PCT/JP2016/078158
(87) International publication number: WO 2017/057216

(56) References cited:
- EP-A1- 2 270 077
- JP-A- 2000 144 074
- JP-A- 2004 083 636
- JP-A- 2015 005 646
- US-A1- 2011 023 943

## Description

### TECHNICAL FIELD

The present invention relates to an insulating multilayer sheet and a solar cell module.

### BACKGROUND ART

Under the circumstances of a recent increase in environmental problems, attention has been paid to solar photovoltaic power generation as clean energy.

A solar cell module used for solar photovoltaic power generation is manufactured using, for example, a lamination method including: laminating a substrate on which sunlight is incident, an encapsulant, a solar cell element, and a back sheet; and heat-pressure bonding the obtained laminate.

In a solar cell module, a plurality of solar cell elements are connected in series by cell connection wire to form a cell string, and wiring is connected from the cell string to external connection wire and is led to a terminal box. Power generated from the solar cell module is output from the terminal box to the outside through output lead wire.

In a manufacturing process of a solar cell module, an insulating sheet is used for accurately positioning a solar cell element, connection wire, lead wire, and the like, improvement of workability, improvement of safety, or the like (for example, refer to Patent Document 1). For example, an insulating sheet is used, for example, for fixing between solar cell elements and an encapsulating resin layer, for fixing between solar cell elements, for fixing and integrating external connection wire from a cell string, or for fixing output lead wire to a frame or the like.

Examples of a technique relating to this insulating sheet include the technique described in Patent Document 1.

Patent Document 1 discloses an adhesive tape in which an adhesive layer such as an acrylic adhesive layer is provided on a resin sheet having hydrolysis resistance and resistance to precipitation of low molecular weight compound.

In addition, a peripheral end portion of a solar cell module is typically fixed by a fixing member having a U-shape in cross-section (for example, refer to Patent Document 2). An insulating sheet is interposed between the peripheral end portion of the solar cell module and the fixing member.

Examples of a technique relating to this insulating sheet include the technique described in Patent Document 2.

Patent Document 2 discloses a sealant for sealing an end portion of a solar cell panel, the sealant including: 100 parts by weight of polyisobutylene and/or butyl rubber; and 100 parts by weight or more and 600 parts by weight or less of a metal hydroxide.

EP2270077 discloses a sealing resin sheet used as sealing material for protecting components of solar cell.

This way, an insulating sheet is used in various parts of a solar cell module.

### RELATED DOCUMENT

### PATENT DOCUMENT

[Patent Document 1] Japanese Unexamined Patent Application Publication No. 2011-32449
[Patent Document 2] Japanese Unexamined Patent Application Publication No. 2010-171400

### SUMMARY OF THE INVENTION

The technical level required for achieving various properties of the insulating sheet has become higher.

According to the investigation by the present inventors, it was found that an insulating sheet of the related art satisfies adhesion performance to some extent but is still insufficient in simultaneously realizing adhesion stability and insulating performance.

The present invention has been made in consideration of the above-described circumstances, and an object thereof is to provide an insulating multilayer sheet having a good performance balance between stability of adhesion with various members of a solar cell module and insulating performance.

### Solution to Problem

The present inventors performed a thorough investigation in order to achieve the object. As a result, adhesion stability and insulating performance can be improved with a good balance by laminating an electrically insulating resin film layer and an adhesive layer including an epoxy group-containing ethylene based copolymer and a specific ethylene based copolymer, thereby completing the present invention.

That is, according to the present invention, an insulating multilayer sheet and a solar cell module described below can be provided.
[1] Use of an insulating multilayer sheet comprising:
   an electrically insulating resin film layer; and
   an adhesive layer that is provided on a single surface or both surfaces of the electrically insulating resin film layer,
   wherein the adhesive layer includes an epoxy group-containing ethylene based copolymer (A) and at least one ethylene based copolymer (B) (excluding the epoxy group-containing ethylene based copolymer (A)) selected from the group consisting of an ethylene/polar monomer copolymer and an ethylene/α-olefin copolymer having a density of 920 kg/m³ or lower, and
   wherein the insulating multilayer sheet is used for fixing a solar cell module to a fixing member and encapsulating an end portion of the solar cell module; or
   wherein the insulating multilayer sheet is used for fixing a solar cell element and an encapsulating resin layer to each other and/or fixing solar cell elements to each other.
[2] The use according to [1],
   wherein a breakdown voltage measured according to JIS C 2110-1 under conditions of a temperature of 23±2°C, a humidity of 50±5% RH, and a pressure increase rate of 2.0 kV/sec is 12 kV or higher.
[3] The use according to [1] or [2]
   wherein the epoxy group-containing ethylene based copolymer (A) includes at least one selected from the group consisting of an ethylene/glycidyl (meth)acrylate copolymer, an ethylene/glycidyl (meth)acrylate/vinyl acetate copolymer, and an ethylene/glycidyl (meth)acrylate/(meth)acrylic acid ester copolymer.
[4] The use according to any one [1] to [3],
   wherein the ethylene/polar monomer copolymer includes at least one selected from the group consisting of an ethylene/vinyl ester copolymer, an
   ethylene/unsaturated carboxylic acid ester copolymer, and an ethylene/unsaturated carboxylic acid copolymer.
[5] The use according to any one [1] to [4],
   wherein at least a part of the epoxy group-containing ethylene based copolymer (A) and the ethylene based copolymer (B) in the adhesive layer is graft-modified by a silane coupling agent.
[6] The use according to any one [1] to [5],
   wherein a content of the ethylene based copolymer (B) in the adhesive layer is 50 mass% or higher and 99 mass% or lower with respect to 100 mass% of a total amount of the epoxy group-containing ethylene based copolymer (A) and the ethylene based copolymer (B).
[7] The use according to any one [1] to [5],
   wherein the electrically insulating resin film layer is formed of at least one resin selected from the group consisting of polyethylene terephthalate, polybutylene terephthalate, polymethyl (meth)acrylate, and fluorine-based resin.
[8] A solar cell module comprising:
   a substrate on which sunlight is incident;
   a solar cell element;
   a back sheet;
   an encapsulating resin layer that encapsulates the solar cell element between the substrate and the back sheet; and
   an insulating multilayer sheet comprising:
      an electrically insulating resin film layer; and
      an adhesive layer that is provided on a single surface or both surfaces of the electrically insulating resin film layer,
      wherein the adhesive layer includes an epoxy group-containing ethylene based copolymer (A) and at least one ethylene based copolymer (B) (excluding the epoxy group-containing ethylene based copolymer (A)) selected from the group consisting of an ethylene/polar monomer copolymer and an ethylene/α-olefin copolymer having a density of 920 kg/m³ or lower, and
      wherein the insulating multilayer sheet encapsulates an end portion of the solar cell module and fixes the solar cell module to a fixing member; or
      wherein the insulating multilayer sheet fixes the solar cell element and the encapsulating resin layer to each other and/or fixes the solar cell elements to each other.
[9] The solar cell module according to [8],
   wherein a breakdown voltage measured according to JIS C 2110-1 under conditions of a temperature of 23±2°C, a humidity of 50±5% RH, and a pressure increase rate of 2.0 kV/sec is 12 kV or higher.
[10] The solar cell module according to any one of [8] to [9],
   wherein the epoxy group-containing ethylene based copolymer (A) includes at least one selected from the group consisting of an ethylene/glycidyl (meth)acrylate copolymer, an ethylene/glycidyl (meth)acrylate/vinyl acetate copolymer, and an ethylene/glycidyl (meth)acrylate/(meth)acrylic acid ester copolymer.
[11] The solar cell module according to any one of [8] to [10],
   wherein the ethylene/polar monomer copolymer includes at least one selected from the group consisting of an ethylene/vinyl ester copolymer, an ethylene/unsaturated carboxylic acid ester copolymer, and an ethylene/unsaturated carboxylic acid copolymer.
[12] The solar cell module according to any one of [8] to [11],
   wherein at least a part of the epoxy group-containing ethylene based copolymer (A) and the ethylene based copolymer (B) in the adhesive layer is graft-modified by a silane coupling agent.
[13] The solar cell module according to any one of [8] to [12],
   wherein a content of the ethylene based copolymer (B) in the adhesive layer is 50 mass% or higher and 99 mass% or lower with respect to 100 mass% of a total amount of the epoxy group-containing ethylene based copolymer (A) and the ethylene based copolymer (B).
[14] The solar cell module according to any one of [8] to [13],
   wherein the electrically insulating resin film layer is formed of at least one resin selected from the group consisting of polyethylene terephthalate, polybutylene terephthalate, polymethyl (meth)acrylate, and fluorine-based resin.

According to the present invention, an insulating multilayer sheet having a good performance balance between stability of adhesion with various members of a solar cell module and insulating performance can be provided.

### BRIEF DESCRIPTION OF THE DRAWINGS

The above-described object, other objects, characteristics, and advantageous effects will be further described in detail using the following preferred embodiments and the accompanying drawings.
Fig. 1 is a cross-sectional view schematically showing an example of a structure of an insulating multilayer sheet according to an embodiment of the present invention.
Fig. 2 is a cross-sectional view schematically showing an example of a structure of a solar cell module according to an embodiment of the present invention.
Fig. 3 is a plan view showing a state where a solar cell element and an encapsulating resin layer are fixed and the solar cell elements are fixed using the insulating multilayer sheet in the solar cell module according to the embodiment of the present invention.

### DESCRIPTION OF EMBODIMENTS

Hereinafter, embodiments of the present invention will be described using the drawings. "X to Y" in a numerical range represents "X or more and Y or less" unless specified otherwise. In addition, "(meth)acryl represents either or both of acryl and methacryl.

### 1. Regarding Insulating Multilayer Sheet

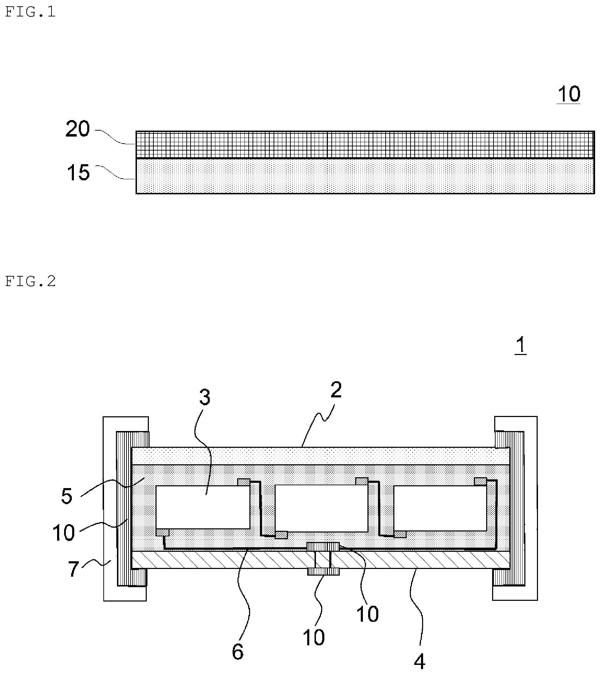

Fig. 1 is a cross-sectional view schematically showing an example of a structure of an insulating multilayer sheet 10 according to an embodiment of the present invention.

The insulating multilayer sheet 10 (hereinafter, also referred to as "multilayer sheet") according to the embodiment is, for example, an insulating sheet for a solar cell and includes: an electrically insulating resin film layer 15; and an adhesive layer 20 that is provided on a single surface or both surfaces of the electrically insulating resin film layer 15.

The embodiment includes a configuration in which a layer other than the electrically insulating resin film layer 15 and the adhesive layer 20 is provided between the electrically insulating resin film layer 15 and the adhesive layer 20, but it is more preferable that the electrically insulating resin film layer 15 and the adhesive layer 20 are in direct contact with each other.

The adhesive layer 20 includes an epoxy group-containing ethylene based copolymer (A) and at least one ethylene based copolymer (B) (excluding the epoxy group-containing ethylene based copolymer (A)) selected from the group consisting of an ethylene/polar monomer copolymer and an ethylene/α-olefin copolymer having a density of 920 kg/m³ or lower

In the insulating multilayer sheet 10 according to the embodiment including the electrically insulating resin film layer 15 and the adhesive layer 20, adhesion stability and insulating performance can be improved with a good balance as compared to an insulating sheet which is used in the related art. In particular, moisture resistance and adhesion performance are superior. Therefore, wet adhesion performance and long-term adhesion stability are superior. In addition, the adhesive layer 20 according to the embodiment also has superior adhesion performance with a surface of the electrically insulating resin film layer 15 such as a polyester film that is not corona-treated. That is, at least one surface of the electrically insulating resin film layer 15 may not be corona-treated. In addition, a surface of the electrically insulating resin film layer 15 in contact with the adhesive layer 20 may not be corona-treated.

In the embodiment, the total thickness of the insulating multilayer sheet 10 is preferably 10 µm or more and 500 µm or less, more preferably 15 µm or more and 400 µm or less, and still more preferably 30 µm or more and 300 µm or less.

In addition, the insulating multilayer sheet 10 according to the embodiment has a good performance balance between adhesion stability and insulating performance. Therefore, the total thickness of the insulating multilayer sheet 10 can be 250 µm or less.

In the insulating multilayer sheet 10 according to the embodiment, a breakdown voltage measured according to JIS C 2110-1 under conditions of a temperature of 23±2°C, a humidity of 50±5% RH, and a pressure increase rate of 2.0 kV/sec is preferably 12 kV or higher and more preferably 14 kV or higher. In a case where the breakdown voltage satisfies the above-described range, insulation reliability of the insulating multilayer sheet 10 can be further improved.

In the insulating multilayer sheet 10 according to the embodiment, a bending rigidity of the adhesive layer 20 measured according to JIS K 7106 is preferably 200 MPa or lower and more preferably 150 MPa or lower. In a case where the bending rigidity satisfies the above-described range, a performance balance between adhesion performance and other performances such as breaking strength, impact resistance, protrusion resistance, or unevenness followability in the insulating multilayer sheet 10 can be further improved. In order to achieve the above-described bending rigidity, the composition, thickness, or the like of the adhesive layer 20 may be appropriately adjusted.

In the adhesive layer 20 of the insulating multilayer sheet 10 according to the embodiment, a water-vapor permeability measured according to JIS Z 0208 under conditions of a temperature of 40°C and a humidity of 90% RH is preferably 15 g/(m²·24h) or lower, more preferably 10 g/ (m²·24h) or lower, and still more preferably 5 g/ (m²·24h) or lower.

In the insulating multilayer sheet 10 in which the water-vapor permeability is the upper limit value or lower, the moisture resistance of the adhesive layer is high. Therefore, the wet adhesion performance or the long-term adhesion stability of the insulating multilayer sheet 10 can be further improved.

### <Electrically Insulating Resin Film Layer>

The electrically insulating resin film layer 15 is, for example, a film or a sheet that is formed of one resin or two or more resins selected from the group consisting of an olefin resin such as polyethylene or polypropylene; an ester resin such as polyethylene terephthalate (PET), polyethylene naphthalate, or polybutylene terephthalate (PBT); an amide resin such as Nylon (trade name); a carbonate resin; a styrene resin; a vinyl alcohol resin such as polyvinyl alcohol; an ethylene/vinyl ester resin such as an ethylene/vinyl acetate copolymer (EVA); an acrylonitrile resin; a vinyl chloride resin; a vinyl acetal resin; polymethyl (meth)acrylate; and fluorine-based resin. Among these, a film or a sheet that is formed of at least one resin selected from the group consisting of polyethylene terephthalate, polybutylene terephthalate, polymethyl (meth)acrylate, and fluorine-based resin is preferable, and a film or a sheet that is formed of polyethylene terephthalate is more preferable.

A single surface or both surfaces of the electrically insulating resin film layer 15 may be treated in order to further improve adhesion performance with the adhesive layer or another member. Examples of a method of the surface treatment include a sand treatment, a flame treatment, a corona discharge treatment, a plasma discharge treatment, and an arc discharge treatment.

The thickness of the electrically insulating resin film layer 15 is not particularly limited, and from the viewpoint of reduction in weight and electrical insulating performance, is preferably in a range of 10 µm or more and 300 µm or less, more preferably in a range of 20 µm or more and 250 µm or less, and still more preferably in a range of 30 µm or more and 200 µm or less.

### <Adhesive Layer>

The adhesive layer 20 includes an epoxy group-containing ethylene based copolymer (A) and at least one ethylene based copolymer (B) (excluding the epoxy group-containing ethylene based copolymer (A)) selected from the group consisting of an ethylene/polar monomer copolymer and an ethylene/α-olefin copolymer having a density of 920 kg/m³ or lower.

Examples of the epoxy group-containing ethylene based copolymer (A) include a glycidyl group-containing ethylene based copolymer.

Examples of the glycidyl group-containing ethylene based copolymer include at least one selected from the group consisting of an ethylene/glycidyl (meth)acrylate copolymer, an ethylene/glycidyl (meth)acrylate/vinyl acetate copolymer, and an ethylene/glycidyl (meth)acrylate/(meth)acrylic acid ester copolymer.

The epoxy group-containing ethylene based copolymer (A) is obtained by copolymerization of ethylene and a monomer having a polymerizable group and an epoxy group such as glycidyl (meth)acrylate, vinyl glycidyl ether, 1,2-epoxy-4-vinylcyclohexane, or 3,4-epoxycyclohexylmethyl methacrylate. In addition, an epoxy group may be introduced into the ethylene based copolymer by graft polymerization with a monomer having an epoxy group.

A content ratio of a constitutional unit derived from a monomer such as glycidyl (meth)acrylate in the epoxy group-containing ethylene based copolymer (A) is preferably 2 mass% or higher and 30 mass% or lower and more preferably 3 mass% or higher and 25 mass% or lower.

In a case where the content ratio of the constitutional unit derived from the monomer such as glycidyl (meth)acrylate is the lower limit value or higher, adhesion performance between the insulating multilayer sheet 10 and members constituting a solar cell module (for example, a solar cell element, an encapsulating resin layer, wiring, a substrate, or a back sheet) is further improved. In addition, in a case where the content ratio of the constitutional unit derived from the monomer such as glycidyl (meth)acrylate is the upper limit value or lower, workability is high, and the transparency of the insulating multilayer sheet 10 is also further improved.

"Glycidyl (meth)acrylate" represents either or both of glycidyl methacrylate and glycidyl acrylate.

"The ethylene based copolymer" in the epoxy group-containing ethylene based copolymer (A) represents a copolymer having a constitutional unit derived from ethylene as a major component. Further, "the major component" described herein represents that the content of "the constitutional unit derived from ethylene" with respect to the total amount of all the constitutional units is the highest. For example, in the case of a copolymer formed of constitutional units which are derived from ethylene, glycidyl (meth)acrylate, and vinyl acetate, respectively, "the major component" represents that the proportion of the constitutional unit derived from ethylene is higher than that of a constitutional unit derived from glycidyl (meth)acrylate or a constitutional unit derived from vinyl acetate.

The proportion of "the constitutional unit derived from ethylene" in the epoxy group-containing ethylene based copolymer (A) is preferably 50 mass% or higher, more preferably 65 mass% or higher, still more preferably 70 mass% or higher, and even still more preferably 80 mass% or higher.

At this time, the epoxy group-containing ethylene based copolymer may further include other monomer units other than ethylene and the monomer having a polymerizable group and an epoxy group.

Examples of the other monomers include: a vinyl ester such as vinyl acetate or vinyl propionate; and an unsaturated carboxylic acid ester such as acrylic acid ester, methacrylic acid ester, ethacrylic acid ester, crotonic acid ester, fumaric acid ester, maleic acid ester, maleic anhydride ester, itaconic acid ester, or itaconic anhydride ester. As an ester group, an alkyl ester group having 1 to 12 carbon atoms can be used, and specific examples of the alkyl ester group include methyl ester, ethyl ester, n-propyl ester, isopropyl ester, n-butyl ester, isobutyl ester, secondary butyl ester, 2-ethylhexyl ester, and isooctyl ester.

Among these, at least one selected from the group vinyl acetate and (meth)acrylic acid ester is preferable.

Specifically, for example, not only a copolymer including a constitutional unit derived from ethylene and a constitutional unit derived from glycidyl (meth)acrylate but also a copolymer further including at least a constitutional unit derived from vinyl acetate or a constitutional unit derived from (meth)acrylic acid ester in addition to the above-described two constitutional units may be used.

A content ratio of the constitutional unit derived from a vinyl ester such as vinyl acetate and a constitutional unit derived from an unsaturated carboxylic acid ester such as (meth)acrylic acid ester is preferably 30 mass% or lower and more preferably 20 mass% or lower. As a result, the water-vapor permeability of the insulating multilayer sheet 10 decreases and the moisture resistance can be further improved.

The lower limit value of the content ratio of the constitutional unit derived from a vinyl ester such as vinyl acetate and a constitutional unit derived from an unsaturated carboxylic acid ester such as (meth)acrylic acid ester is not particularly limited and is preferably 0.1 mass% or higher, more preferably 0.5 mass% or higher, and still more preferably 1 mass% or higher. Further, the content ratio of the constitutional unit derived from a vinyl ester such as vinyl acetate or a constitutional unit derived from an unsaturated carboxylic acid ester such as (meth)acrylic acid ester is preferably 0.1 mass% or higher and 30 mass% or lower, more preferably 0.5 mass% or higher and 20 mass% or lower, and even still more preferably 1 mass% or higher and 20 mass% or lower.

As the epoxy group-containing ethylene based copolymer (A), one kind may be used alone, or two or more kinds having different copolymerization ratios may be used in combination.

The content of the epoxy group-containing ethylene based copolymer (A) in the adhesive layer 20 is preferably 1 mass% or higher and 25 mass% or lower, more preferably 2 mass% or higher and 15 mass% or lower, and still more preferably 3 mass% or higher and 10 mass% or lower with respect to 100 mass% of the total amount of the epoxy group-containing ethylene based copolymer (A) and the ethylene based copolymer (B). By adjusting the content of the epoxy group-containing ethylene based copolymer (A) to be in the above-described range, a performance balance between transparency, adhesion performance, moisture resistance, insulating performance, flexibility, heat resistance, and workability can be further improved.

The ethylene based copolymer (B) includes at least one selected from the group consisting of an ethylene/polar monomer copolymer and an ethylene/α-olefin copolymer having a density of 920 kg/m³ or lower.

"The ethylene based copolymer" in the ethylene based copolymer (B) represents a copolymer having a constitutional unit derived from ethylene as a major component. Further, "the major component" described herein represents that the proportion of "the constitutional unit derived from ethylene" is preferably 50 mass% or higher, more preferably 60 mass% or higher, still more preferably 65 mass% or higher, and even still more preferably 70 mass% or higher with respect to the total amount of all the constitutional units.

The ethylene/polar monomer copolymer may be one kind or two or more kinds selected from the group consisting of an ethylene/vinyl ester copolymer such as an ethylene/vinyl acetate copolymer, an ethylene/vinyl propionate copolymer, an ethylene/vinyl butyrate copolymer, or an ethylene/vinyl stearate copolymer; an ethylene/unsaturated carboxylic acid ester copolymer; and an ethylene/unsaturated carboxylic acid copolymer.

Here, the ethylene/unsaturated carboxylic acid ester copolymer is a polymer obtained by copolymerization of ethylene and at least one unsaturated carboxylic acid ester.

Specifically, for example, a copolymer including ethylene and an unsaturated carboxylic acid alkyl ester can be used.

Examples of the unsaturated carboxylic acid in the unsaturated carboxylic acid ester include acrylic acid, methacrylic acid, ethacrylic acid, crotonic acid, fumaric acid, maleic acid, maleic anhydride, itaconic acid, and itaconic anhydride.

As an alkyl site in the unsaturated carboxylic acid alkyl ester, for example, a group having 1 to 12 carbon atoms can be used, and specific examples thereof include an alkyl group such as methyl, ethyl, n-propyl, isopropyl, n-butyl, isobutyl, secondary butyl, 2-ethylhexyl, and isooctyl. In the embodiment, the number of carbon atoms at the alkyl site of the alkyl ester is preferably 1 to 8.

In the embodiment, as the ethylene/unsaturated carboxylic acid ester copolymer, an ethylene/(meth)acrylic acid ester copolymer is more preferable. Examples of the copolymer include an ethylene/methyl acrylate copolymer, an ethylene/ethyl acrylate copolymer, an ethylene/normal butyl acrylate copolymer, an ethylene/isobutyl acrylate copolymer, an ethylene/methyl methacrylate copolymer, an ethylene/ethyl methacrylate copolymer, an ethylene/normal butyl methacrylate copolymer, and an ethylene/isobutyl methacrylate copolymer.

Here, the ethylene/unsaturated carboxylic acid copolymer is a polymer obtained by copolymerization of ethylene and at least one unsaturated carboxylic acid. The unsaturated carboxylic acid ester may be copolymerized.

Specifically, for example, a copolymer including ethylene and an unsaturated carboxylic acid can be used.

Examples of the unsaturated carboxylic acid include acrylic acid, methacrylic acid, ethacrylic acid, crotonic acid, fumaric acid, maleic acid, maleic anhydride, itaconic acid, and itaconic anhydride.

In the embodiment, as the ethylene/unsaturated carboxylic acid copolymer, an ethylene/(meth)acrylic acid copolymer is more preferable.

The ethylene/polar monomer copolymer is more preferably at least one selected from the group consisting of an ethylene/vinyl acetate copolymer, an ethylene/methyl (meth)acrylate copolymer, an ethylene/ethyl (meth)acrylate copolymer, an ethylene/propyl (meth)acrylate copolymer, an ethylene/butyl (meth)acrylate copolymer, and an ethylene/(meth)acrylic acid copolymer. As the resin in the embodiment, one kind may be used alone, and two or more kinds may be blended and used.

The content of a polar monomer in the ethylene/polar monomer copolymer is preferably 5 mass% or higher and 40 mass% or lower, more preferably 8 mass% or higher and 35 mass% or lower, and still more preferably 8 mass% or higher and 30 mass% or lower.

In a case where the content of the polar monomer is in the above-described range, a balance between adhesion performance, transparency, mechanical properties, and film forming properties in the insulating multilayer sheet 10 can be further improved. The content of vinyl acetate can be measured, for example, according to JIS K 7192:1999.

A method of manufacturing the ethylene/polar monomer copolymer is not particularly limited and can be manufactured using a well-known method. For example, the ethylene/polar monomer copolymer can be manufactured using an autoclave method or a tubular method which is a highpressure well-known method of the related art. In addition, a commercially available product may be used as the ethylene/polar monomer copolymer.

In the ethylene/α-olefin copolymer having a density of 920 kg/m³ or lower in the ethylene based copolymer (B), it is preferable that the content ratio of a constitutional unit derived from α-olefin having 3 to 20 carbon atoms is 5 mol% or higher and more preferably 10 mol% or higher with respect to 100 mol% of the content of all the constitutional units (monomer units) constituting the copolymer. In a case where the content ratio of the constitutional unit derived from the α-olefin is in the above-described range, the transparency and bleed resistance of the multilayer sheet can be further improved. In addition, in consideration of the flexibility of the multilayer sheet, it is preferable that a polymer in which the content ratio of the constitutional unit derived from the α-olefin is 15 mol% or higher is used. The upper limit is lower than 50 mol%, preferably 40 mol% or lower, and more preferably 30 mol% or lower.

Specific examples of α-olefin having 3 to 20 carbon atoms include: a linear α-olefin such as propylene, 1-butene, 1-pentene, 1-hexene, 1-heptene, 1-octene, 1-nonene, 1-decene, 1-undecene, 1-dodecene, 1-tridecene, 1-tetradecene, 1-heptadecene, 1-hexadecene, 1-heptadecene, 1-octadecene, 1-nanodecene, or 1-eicosene; and a branched α-olefin such as 3-methyl-1-butene, 3-methyl-1-pentene, 4-methyl-1-pentene, 2-ethyl-1-hexene, or 2,2,4-trimethyl-1-pentene. Among these, a combination of two or more kinds may also be used.

From the viewpoint of versatility (cost, mass productivity, or easy availability), the number of carbon atoms in the α-olefin is preferably 3 to 10 and more preferably 3 to 8.

As the ethylene/α-olefin copolymer, an ethylene/propylene copolymer, an ethylene/1-butene copolymer, an ethylene/4-methyl-1-pentene copolymer, an ethylene/1-hexene copolymer, or an ethylene/1-octene copolymer is preferable. In each of all the ethylene/α-olefin copolymers, the content of the constitutional unit derived from ethylene is 50 mol% or higher.

In each of the copolymers, the proportion of the constitutional unit derived from α-olefin is preferably 5 mol% or higher and more preferably 10 mol% or higher with respect to 100 mol% of the total amount of all the constitutional units (monomer units) constituting the copolymer.

As the ethylene/α-olefin copolymer in the adhesive layer 20, one kind may be used alone, or a combination of two or more kinds may be used.

The ethylene/α-olefin copolymer can be manufactured, for example, using a metallocene catalyst and a slurry polymerization method, a solution polymerization method, a block polymerization method, or a vapor phase polymerization method.

The density of the ethylene/α-olefin copolymer measured according to JIS K 7112 is preferably 850 kg/m³ or higher, more preferably 860 kg/m³ or higher, and still more preferably 870 kg/m³ or higher. By adjusting the density of the ethylene/α-olefin copolymer to be the lower limit value or higher, heat resistance can be further improved.

The density of the ethylene/α-olefin copolymer measured according to JIS K 7112 is preferably 920 kg/m³ or lower and more preferably 910 kg/m³ or lower. By adjusting the density of the ethylene/α-olefin copolymer to be the upper limit value or lower, a balance between adhesion performance, flexibility, and transparency in the multilayer sheet can be further improved.

The content of the ethylene based copolymer (B) in the adhesive layer 20 is preferably 50 mass% or higher and 99 mass% or lower, more preferably 75 mass% or higher and 99 mass% or lower, still more preferably 85 mass% or higher and 98 mass% or lower, and even still more preferably 90 mass% or higher and 97 mass% or lower with respect to 100 mass% of the total amount of the epoxy group-containing ethylene based copolymer (A) and the ethylene based copolymer (B). By adjusting the content of the ethylene based copolymer (B) to be in the above-described range, a performance balance between transparency, adhesion performance, moisture resistance, insulating performance, flexibility, heat resistance, and workability can be further improved.

It is preferable that at least a part of the epoxy group-containing ethylene based copolymer (A) and the ethylene based copolymer (B) in the adhesive layer 20 is graft-modified by a silane coupling agent. As a result, a performance balance between adhesion performance and workability in the insulating multilayer sheet 10 can be further improved.

Here, examples of a method of the graft modification of the silane coupling agent to the epoxy group-containing ethylene based copolymer (A) and the ethylene based copolymer (B) include: a method (graft modification method 1) of causing the epoxy group-containing ethylene based copolymer (A) or the ethylene based copolymer (B) to react with a silane coupling agent having an amino group or an epoxy group while heating the components (for example, 100°C or higher and 200°C or lower); and a method (graft modification method 2) of performing graft polymerization of a silane coupling agent having a polymerizable group with the epoxy group-containing ethylene based copolymer (A) or the ethylene based copolymer (B) using a polymerization initiator.

In the graft modification method 1, the amino group or the epoxy group in the silane coupling agent reacts with the epoxy group or the carboxyl group in the epoxy group-containing ethylene based copolymer (A) or the ethylene based copolymer (B) such that the silane coupling agent is grafted to a side chain of the epoxy group-containing ethylene based copolymer (A) or the ethylene based copolymer (B).

In the graft modification method 2, for example, the epoxy group-containing ethylene based copolymer (A) or the ethylene based copolymer (B), a silane coupling agent having a polymerizable group, and a radical polymerization initiator are kneaded using an extruder, a kneader, a Banbury mixer, or the like while melting them at a temperature which is higher or equal to a melting point of the epoxy group-containing ethylene based copolymer (A) or the ethylene based copolymer (B) and is higher or equal to a decomposition temperature of the radical polymerization initiator. As a result, the ethylene/polar monomer copolymer can be manufactured. These reactions can be performed in a solution.

As the polymerization initiator used for the graft modification, a typically used polymerization initiator can be used, and an organic peroxide is preferable.

As the organic peroxide, a well-known organic peroxide which can be used as a polymerization initiator can be used, and specific examples thereof include a diacyl peroxide compound, an alkyl peroxy ester compound, a peroxy dicarbonate compound, a peroxy carbonate compound, a peroxy ketal compound, a dialkyl peroxide compound, a hydroperoxide compound, and a ketone peroxide compound.

Among these, a dialkyl peroxide compound is preferable, and 2,5-dimethyl-2,5-di(t-butylperoxy)hexane, 1,3-di(2-t-butylperoxyisopropyl)benzene, di-t-butyl peroxide, or 2,5-dimethyl-2,5-di(t-(butylperoxy)hexyne-3 is more preferable.

The content of the polymerization initiator is typically 0.1 parts by mass or more and 5 parts by mass or less and preferably 0.5 parts by mass or more and 3 parts by mass or less with respect to 100 parts by mass of the total amount of the epoxy group-containing ethylene based copolymer (A) and the ethylene based copolymer (B).

Examples of the silane coupling agent having a polymerizable group include vinyltrimethoxysilane, vinyltriethoxysilane, 3-methacryloxypropylmethyldimethoxysilane, 3-methacryloxypropyltrimethoxysilane, 3-methacryloxypropylmethyldiethoxysilane, 3-methacryloxypropyltriethoxysilane, 3-acryloxypropylmethyldimethoxysilane, 3-acryloxypropyltrimethoxysilane, 3-acryloxypropylmethyldiethoxysilane, and 3-acryloxypropyltriethoxysilane.

Examples of the silane coupling agent having an amino group include hydrochlorides of N-(2-aminoethyl)-3-aminopropyltrimethoxysilane, N-(2-aminoethyl)-3-aminopropylmethyldimethoxysilane, N-2-(aminoethyl)-3-aminopropyltriethoxysilane, 3-aminopropyltrimethoxysilane, 3-aminopropyltriethoxysilane, 3-triethoxysilyl-N-(1,3-dimethyl-butylidene)propylamine, N-phenyl-3-aminopropyltrimethoxysilane, and N-(vinylbenzyl)-2-aminoethyl-3-aminopropyltrimethoxysilane.

Examples of the silane coupling agent having an epoxy group include 2-(3,4-epoxycyclohexyl)ethyltrimethoxysilane, 3-glycidoxypropylmethyldimethoxysilane, 3-glycidoxypropyltrimethoxysilane, 3-glycidoxypropylmethyldiethoxysilane, and 3-glycidoxypropyltriethoxysilane.

The content of the silane coupling agent is typically 5 parts by mass or less and preferably 0.02 parts by mass or more and 3 parts by mass or less with respect to 100 parts by mass of the total amount of the epoxy group-containing ethylene based copolymer (A) and the ethylene based copolymer (B). In a case where the content of the silane coupling agent is in the above-described range, the adhesion performance of the multilayer sheet can be further improved.

In both the epoxy group-containing ethylene based copolymer (A) and the ethylene based copolymer (B), it is preferable that a melt flow rate (JIS K 7210-1999, 190°C, load: 2160 g; hereinafter, abbreviated as "MFR") is in a range of 0.1 g/10 min or higher and 50 g/10 min or lower. Further, MFR is preferably in a range of 0.5 g/10 min or higher and 30 g/10 min or lower and more preferably in a range of 1 g/10 min or higher and 20 g/10 min or lower. By selecting the copolymer in the above-described range, workability on a sheet required as the insulating multilayer sheet 10 can be further improved, and a desired sheet can be obtained.

In the adhesive layer 20, the total content of the epoxy group-containing ethylene based copolymer (A) and the ethylene based copolymer (B) is preferably 50 mass% or higher, more preferably 65 mass% or higher, still more preferably 80 mass% or higher, and even still more preferably 90 mass% or higher with respect to 100 mass% of the total amount of the adhesive layer 20. In a case where the total content of the epoxy group-containing ethylene based copolymer (A) and the ethylene based copolymer (B) is in the above-described range, a performance balance between transparency, adhesion performance, moisture resistance, insulating performance, flexibility, heat resistance, and workability can be further improved.

The adhesive layer 20 may include various additives in a range where the object of the present invention can be achieved. Examples of the additives include a crosslinking agent, a crosslinking aid, a silane coupling agent, an ultraviolet absorber, a light stabilizer, and an antioxidant.

The additives are used for, for example, modifying a resin or improving durability.

As the crosslinking agent, an organic peroxide having a 1 hour half-life decomposition temperature of typically 90°C or higher and 180°C or lower and preferably 100°C or higher and 150°C or lower is preferably used. Examples of the organic peroxide include t-butylperoxy isopropyl carbonate, t-butylperoxy acetate, t-butylperoxy benzoate, dicumyl peroxide, 2,5-dimethyl-2,5-bis(t-butylperoxy)hexane, di-t-butyl peroxide, 2,5-dimethyl-2,5-bis(t-butylperoxy)hexyne-3,1,1-bis(t-butylperoxy)-3,3,5-trimethylcyclohexane, 1,1-bis(t-butylperoxy)cyclohexane, methyl ethyl ketone peroxide, 2,5-dimethylhexyl-2,5-bisperoxy benzoate, t-butyl-hydroperoxide, p-menthane hydroperoxide, benzoyl peroxide, p-chlorobenzoyl peroxide, t-butylperoxy isobutyrate, hydroxyheptyl peroxide, and cyclohexanone peroxide.

The content of the crosslinking agent is typically 0.1 parts by mass or more and 5 parts by mass or less and preferably 0.5 parts by mass or more and 3 parts by mass or less with respect to 100 parts by mass of the total amount of the glycidyl group-containing ethylene based copolymer (A) and the ethylene based copolymer (B).

The crosslinking aid can be optionally used, and examples thereof include a polyunsaturated compound such as a polyallyl compound or a poly(meth)acryloxy compound. Specific examples include: a polyallyl compound such as triallyl isocyanurate, triallyl cyanurate, diallyl phthalate, diallyl fumarate, or diallyl maleate; a poly(meth)acryloxy compound such as ethylene glycol diacrylate, ethylene glycol dimethacrylate, or trimethylolpropane trimethacrylate; and divinylbenzene.

The content of the crosslinking aid is typically 5 parts by mass or less and preferably 0.1 parts by mass or more and 3 parts by mass or less with respect to 100 parts by mass of the total amount of the epoxy group-containing ethylene based copolymer (A) and the ethylene based copolymer (B).

Examples of the silane coupling agent include a silane coupling agent having a vinyl group, an amino group, or an epoxy group and a hydrolyzable group such as an alkoxy group. Specific examples include vinyltrimethoxysilane, γ-methacryloxypropyltrimethoxysilane, γ-methacryloxypropylmethyldimethoxysilane, γ-acryloxypropyltrimethoxysilane, γ-glycidoxypropyltrimethoxysilane, 3-glycidoxypropylmethyldimethoxysilane, 3-glycidoxypropylmethyldiethoxysilane, N-2-(aminoethyl)-3-aminopropyltrimethoxysilane, N-2-(aminoethyl)-3-aminopropylmethyldiethoxysilane, 3-aminopropyltrimethoxysilane, 3-aminopropyltriethoxysilane, N-phenyl-3-aminopropyltrimethoxysilane, and N-phenyl-3-aminopropyltriethoxysilane.

The content of the silane coupling agent is typically 5 parts by mass or less and preferably 0.02 parts by mass or more and 3 parts by mass or less with respect to 100 parts by mass of the total amount of the epoxy group-containing ethylene based copolymer (A) and the ethylene based copolymer (B). In a case where the content of the silane coupling agent is in the above-described range, the adhesion performance of the multilayer sheet can be further improved.

In addition, in order to prevent the multilayer sheet from deteriorating due to ultraviolet light, it is preferable that the adhesive layer 20 includes an ultraviolet absorber, a light stabilizer, and an antioxidant.

Examples of the ultraviolet absorber which can be used include: a benzophenone ultraviolet absorber such as 2-hydroxy-4-methoxybenzophenone, 2,2' -dihydroxy-4-methoxybenzophenone, 2-hydroxy-4-methoxy-2-carboxybenzophenone, or 2-hydroxy-4-n-octoxybenzophenone; a benzotriazole ultraviolet absorber such as 2-(2' - hydroxy-3' ,5' -di-t-butylphenyl)benzotriazole, 2-(2' - hydroxy-5-methylphenyl)benzotriazole, or 2-(2' -hydroxy-5-t-octylphenyl)benzotriazole; and a salicylic acid ester ultraviolet absorber such as phenyl salicylate or p-octylphenyl salicylate.

Examples of the light stabilizer which can be used include a hindered amine light stabilizer.

Examples of the antioxidant which can be used include various antioxidants such as a hindered phenol antioxidant or a phosphite antioxidant.

The content of each of the antioxidant, the light stabilizer, and the ultraviolet absorber is typically 5 parts by mass or less and preferably 0.1 parts by mass or more and 3 parts by mass or less with respect to 100 parts by mass of the total amount of the epoxy group-containing ethylene based copolymer (A) and the ethylene based copolymer (B).

In addition, the adhesive layer 20 may optionally include additives such as a colorant, a light diffusion agent, or a flame retardant other than the above-described additives.

Examples of the colorant include a pigment, an inorganic compound, and a dye. Examples of a white colorant include titanium oxide, zinc oxide, and calcium carbonate.

Examples of an inorganic spherical material as the light diffusion agent include glass beads, silica beads, silicon alkoxy beads, and hollow glass beads. Examples of an organic spherical material as the light diffusion agent include plastic beads such as acrylic beads or vinyl benzene beads.

Examples of the flame retardant include a halogen flame retardant such as a bromide, a phosphorus flame retardant, a silicone flame retardant, and a metal hydrate such as magnesium hydroxide or aluminum hydroxide.

In the embodiment, the total thickness of the adhesive layer 20 is preferably 5 µm or more and 100 µm or less, more preferably 10 µm or more and 90 µm or less, and still more preferably 20 µm or more and 80 µm or less. In a case where the thickness of the adhesive layer 20 is in the above-described range, a performance balance between adhesion stability and insulating performance in the insulating multilayer sheet can be further improved.

The insulating multilayer sheet 10 according to the embodiment can be manufactured using a well-known method using a T-die extruder or the like. For example, a dry blended product (resin composition) or a melt blended product (resin composition) that is melted and kneaded in advance is supplied from a hopper of a T-die extruder and is applied from a tip of the T-die extruder to the electrically insulating resin film layer 15 in the form of a sheet by extrusion coating, wherein the dry blended product or the melt blended product includes an epoxy group-containing ethylene based copolymer (A) and at least one ethylene based copolymer (B) (excluding the epoxy group-containing ethylene based copolymer (A)) selected from the group consisting of an ethylene/polar monomer copolymer and an ethylene/α-olefin copolymer having a density of 920 kg/m³ or lower. As a result, the insulating multilayer sheet 10 according to the embodiment can be obtained.

Here, the above-described various additives may be added to the resin composition.

### 2. Solar Cell Module

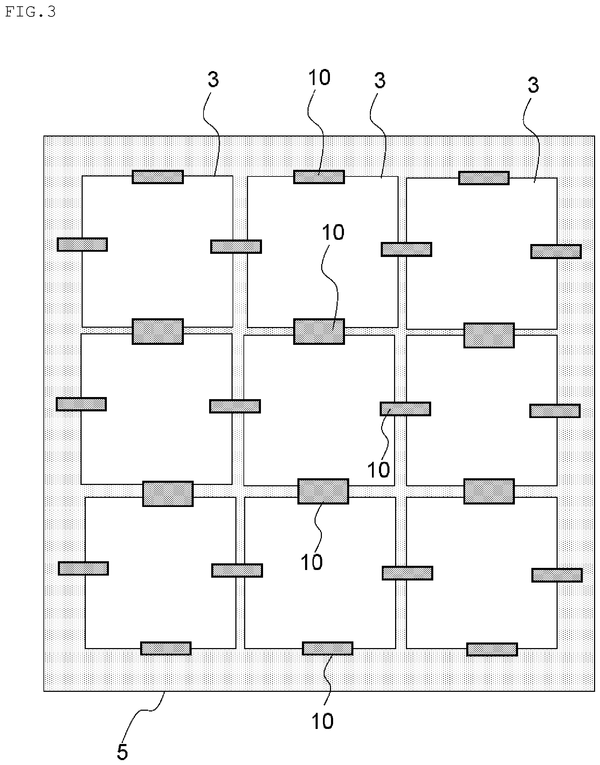

Fig. 2 is a cross-sectional view schematically showing an example of a structure of a solar cell module 1 according to an embodiment of the present invention. In addition, Fig. 3 is a plan view showing a state where a solar cell element 3 and an encapsulating resin layer 5 are fixed and the solar cell element 3 are fixed using the insulating multilayer sheet 10 in the solar cell module 1 according to the embodiment of the present invention.

The solar cell module 1 according to the embodiment includes at least: a substrate 2 on which sunlight is incident; the solar cell element 3; a back sheet 4; the encapsulating resin layer 5 that encapsulates the solar cell element 3 between the substrate 2 and the back sheet 4; and the insulating multilayer sheet 10.

In the solar cell module 1 according to the embodiment, the insulating multilayer sheet 10 is used, for example, for fixing wiring 6 of the solar cell module 1 to a predetermined position, for fixing the solar cell element 3 and the encapsulating resin layer 5 to each other and/or fixing the solar cell element 3 to each other, or for fixing the solar cell module 1 to a fixing member 7 and encapsulating an end portion of the solar cell module 1.

As the solar cell module 1, for example, various types of solar cell modules can be used. Examples of the solar cell module 1 include: a solar cell module (substrate 2/solar cell encapsulant sheet/solar cell element 3/solar cell encapsulant sheet/back sheet 4) having a configuration in which the solar cell element 3 are interposed between solar cell encapsulant sheets from both sides thereof; a solar cell module (substrate 2/solar cell element 3/solar cell encapsulant sheet/back sheet 4) having a configuration in which the solar cell element 3 that are formed in advance are disposed on a surface of the substrate 2 such as glass; and a solar cell module having a configuration in which the solar cell encapsulant sheet and the back sheet 4 are formed on a laminate obtained by forming the solar cell element 3 on an inner peripheral surface of the substrate 2, for example, on a laminate obtained by forming amorphous solar cell element on a fluorine-based resin sheet by sputtering.

Examples of the solar cell element 3 which can be used include various solar cell element formed of a silicon material such as single crystal silicon, polycrystal silicon, or amorphous silicon, or a group III-V or II-VI compound semiconductor material such as gallium-arsenide, copper-indium-selenide, copper-indium-gallium-selenide, or cadmium-telluride.

In the solar cell module 1, a plurality of solar cell elements 3 are electrically connected in series through the wiring 6.

The encapsulating resin layer 5 encapsulates the solar cell elements 3.

The encapsulating resin layer 5 is formed of a solar cell encapsulant sheet. Examples of the solar cell encapsulant sheet include resin sheets formed of, for example, an ethylene/vinyl acetate copolymer (EVA), an ethylene/(meth)acrylic acid copolymer or an ionomer thereof, polyvinyl butyral (PVB), an ethylene/α-olefin copolymer, or silicone. For example, a sheet formed of EVA is preferable.

Examples of the substrate 2 constituting the solar cell module 1 include substrates formed of glass, an acrylic resin, polycarbonate, polyester, a fluorine-containing resin, and the like.

The back sheet 4 is a single-layer or multilayer sheet formed of a metal or various thermoplastic resin films, for example, a single-layer or multilayer sheet formed of a metal such as tin, aluminum, or stainless steel, an inorganic material such as glass, polyester, inorganic vapor-deposited polyester, a fluorine-containing resin, or polyolefin.

The method of manufacturing the solar cell module 1 is not particularly limited and, for example, is as follows.

First, a plurality of solar cell elements 3 that are electrically connected using the wiring 6 are interposed between the solar cell encapsulant sheets. Here, as shown in Fig. 3, using the insulating multilayer sheet 10, the solar cell elements 3 and the encapsulating resin layer 5 may be fixed to each other and/or the solar cell elements 3 may be fixed to each other. As a result, distortion and the like of the solar cell elements 3 during laminating and heating can be prevented, or workability can be improved.

Next, the solar cell encapsulant sheets are interposed between the substrate 2 and the back sheet 4 to prepare a laminate. Next, the laminate is heated and pressed to bond the respective members to each other.

Next, the wiring 6 of the solar cell module 1 can be fixed to a predetermined position, or an end portion of the solar cell module 1 can also be fixed to the fixing member 7 through the insulating multilayer sheet 10 by encapsulating the end portion of the solar cell module 1 using the insulating multilayer sheet 10.

The fixing member 7 is, for example, a frame and is formed of a metal material (for example, aluminum) or a resin material (for example, an acrylic resin) and is preferably formed of a metal material.

In these steps, all the materials may be laminated first and then are heat-pressure bonded all at once through a bonding step using a vacuum laminator.

This way, the solar cell module 1 according to the embodiment is obtained.

Hereinafter, the embodiments of the present invention have been described with reference to the drawings. However, the embodiments are merely examples of the present invention, and various configurations other than the above-described configurations can also be adopted.

### [Examples]

Hereinafter, the present invention will be described in more detail using Examples. However, the present invention is not limited to these Examples.

The details of components used to prepare an insulating multilayer sheet are as follows.

### <EGMAVA-Modified Composition>

### (Manufacturing Example 1)

49 parts of an ethylene/glycidyl methacrylate/vinyl acetate copolymer (EGMAVA, manufactured by Sumitomo Chemical Co., Ltd., BONDFAST 7B, ethylene content: 83 mass%, glycidyl methacrylate content: 12 mass%, vinyl acetate content: 5 mass%, MFR (190°C, load: 2160 g): 7 g/10 min), 49 parts by mass of an ethylene/vinyl acetate copolymer (vinyl acetate content: 19 mass%), 1.5 parts by mass of γ-methacryloxypropyltrimethoxysilane (manufactured by Shin-Etsu Chemical Co., Ltd., trade name "KBM 503"), and 0.5 parts of 2,5-dimethyl-2,5-di(t-butylperoxy)hexane (manufactured by ARKEMA Yoshitomi, Ltd., trade name: "LUPEROX 101") were mixed with each other in advance and were graft-polymerized using a single screw extruder at a melting temperature of 220°C to obtain an EGMAVA-modified composition 1. Here, in the EGMAVA-modified composition 1, EGMAVA (also referred to as "EGMAVA-modified product 1") to which γ-methacryloxypropyltrimethoxysilane was grafted corresponds to the epoxy group-containing ethylene based copolymer (A) according to the embodiment, and the ethylene/vinyl acetate copolymer to which γ-methacryloxypropyltrimethoxysilane was grafted corresponds to the ethylene based copolymer (B) according to the embodiment.

### (Manufacturing Example 2)

In addition, an EGMAVA-modified composition 2 was obtained using the same method as in Manufacturing Example 1, except that an ethylene/methyl acrylate copolymer (ethylene content: 80 mass%, methyl acrylate content: 20 mass%, MFR: 8 g/10 min) was used instead of the ethylene/vinyl acetate copolymer according to Manufacturing Example 1. Here, in the EGMAVA-modified composition 2, EGMAVA (also referred to as "EGMAVA-modified product 2") to which γ-methacryloxypropyltrimethoxysilane was grafted corresponds to the epoxy group-containing ethylene based copolymer (A) according to the embodiment, and the ethylene/methyl acrylate copolymer to which γ-methacryloxypropyltrimethoxysilane was grafted corresponds to the ethylene based copolymer (B) according to the embodiment.

### (Manufacturing Example 3)

In addition, an EGMAVA-modified composition 3 was obtained using the same method as in Manufacturing Example 1, except that an ethylene/α-olefin copolymer (manufactured by Mitsui Chemicals, Inc., TAFMER DF940, MFR: 3.6 g/10 min, density: 893 kg/m³) was used instead of the ethylene/vinyl acetate copolymer according to Manufacturing Example 1. Here, in the EGMAVA-modified composition 3, EGMAVA (also referred to as "EGMAVA-modified product 3") to which γ-methacryloxypropyltrimethoxysilane was grafted corresponds to the epoxy group-containing ethylene based copolymer (A) according to the embodiment, and the ethylene/α-olefin copolymer to which γ-methacryloxypropyltrimethoxysilane was grafted corresponds to the ethylene based copolymer (B) according to the embodiment.

### (Manufacturing Example 4)

In addition, an EGMAVA-modified composition 4 was obtained using the same method as in Manufacturing Example 1, except that the ethylene/vinyl acetate copolymer according to Manufacturing Example 1 was not used. Here, in the EGMAVA-modified composition 4, EGMAVA (also referred to as "EGMAVA-modified product 4") to which γ-methacryloxypropyltrimethoxysilane was grafted corresponds to the epoxy group-containing ethylene based copolymer (A) according to the embodiment.

### <Ethylene based Copolymer (B)>

EVA 1: ethylene/vinyl acetate copolymer (ethylene content: 90 mass%, vinyl acetate content: 10 mass%)
LDPE 1: low-density polyethylene (manufactured by Du Pont-Mitsui Polychemicals Co., Ltd., MIRASON 68P, density: 918 kg/m³)
LDPE 2: low-density polyethylene (manufactured by Du Pont-Mitsui Polychemicals Co., Ltd., MIRASON 401, density: 920 kg/m³)
EMA 1: ethylene/methyl acrylate copolymer (ethylene content: 80 mass%, methyl acrylate content: 20 mass%, MFR: 8 g/10 min)
EEA 1: ethylene/ethyl acrylate copolymer (ethylene content: 85 mass%, ethyl acrylate content: 15 mass%, MFR: 6 g/10 min)
EBA 1: ethylene/butyl acrylate copolymer (ethylene content: 83 mass%, butyl acrylate content: 17 mass%, MFR: 7 g/10 min)
EC1: ethylene/α-olefin copolymer (manufactured by Mitsui Chemicals, Inc., TAFMER DF840, MFR: 3.6 g/10 min, density: 885 kg/m³)
EC2: ethylene/α-olefin copolymer (manufactured by Mitsui Chemicals, Inc., TAFMER DF940, MFR: 3.6 g/10 min, density: 893 kg/m³)
EC3: ethylene/α-olefin copolymer (manufactured by Prime Polymer Co., Ltd., EVOLUE SP0540, MFR: 3.8 g/10 min, density: 903 kg/m³)
EC4: ethylene/α-olefin copolymer (manufactured by Prime Polymer Co., Ltd., EVOLUE SP2540, MFR: 3.8 g/10 min, density: 924 kg/m³)
EVA 2: ethylene/vinyl acetate copolymer (ethylene content: 72 mass%, vinyl acetate content: 28 mass%)

### [Example 1]

Using an L-450-V40 type extrusion laminator (manufactured by Tanabe Plastics Machinery Co., Ltd.), a resin composition (1) was applied at a resin temperature of 180°C by extrusion coating in the form of a sheet such that a thickness ratio of a polyethylene terephthalate (PET) film (manufactured by Toray Industries, Inc., LUMIRROR S10, 100 µm, not corona-treated)/adhesive layer was 1.5/1. As a result, a multilayer sheet having a total thickness of 167 µm (0.167 mm) was prepared. Here, the resin composition (1) is a resin composition obtained by dry-blending 10 parts by mass of the EGMAVA-modified composition 1 and 90 parts by mass of EVA 1 as the ethylene based copolymer (B). The adhesive layer is a layer formed of the resin composition (1).

### <Evaluation>

### (1) Evaluation of Adhesion Performance

Using a vacuum heat bonding machine (double chamber bonding machine manufactured by NPC, LM-50×50S), glass having a thickness of 3.2 mm and the obtained multilayer sheet (the adhesive layer was on the glass side) were laminated in this order and bonded under conditions of a heating temperature of 160°C and a heating time of 8 minutes. Next, the bonded laminate was left to stand in air and was allowed to slowly cool. A slit having a width of 15 mm was formed in the sheet portion of the completed laminate to prepare a test piece, and the test piece was mounted on a tensile tester. The PET of the multilayer sheet was pulled away at a tension rate of 100 mm/min, and the maximum stress was obtained as an initial adhesion strength (N/15 mm).

In addition, the laminate was stored under conditions of 85°C and a humidity of 90% RH for 1000 hours to obtain an adhesion strength after 500 hours and an adhesion strength for 1000 hours, respectively. The obtained adhesion strength was obtained as a PET adhesion strength of the laminate. The obtained results are shown in Table 2.

### (2) Bending Rigidity

The bending rigidity of the multilayer sheet was measured at 23°C according to JIS K 7106. The obtained results are shown in Table 2.

### (3) Breakdown Voltage

According to JIS C 2110-1, the breakdown voltage of the multilayer sheet was measured using a HAT-300-100 RHO type machine (manufactured by Yamazaki Corporation) under conditions of temperature: 23±2°C, humidity: 50±5% RH, pressure increase rate: 2.0 kV/sec, and electrode size: cylindrical shape having a diameter φ of 25 mm. The obtained results are shown in Table 2.

### [Examples 2 to 10, Comparative Examples 1 to 4]

Multilayer sheets were prepared using the same method as in Example 1, except that resin compositions shown in Tables 1 to 3 were used as the adhesive layer instead of the resin composition (1), respectively. Using the multilayer sheets, the same evaluations as in Example 1 were performed. The obtained results are shown in Tables 2 and 3.

### [Comparative Example 5]

Using a single screw extruder, the resin composition (1) was extruded into the form of a sheet at a resin temperature of 180°C to prepare a resin sheet having a thickness of 167 µm (0.167 mm). Using the resin sheet, the same evaluations as in Example 1 were performed. The obtained results are shown in Table 3.

**Table 1**

| | Resin Composition | (1) | (2) | (3) | (4) | (5) | (6) | (7) | (8) | (9) | (10) | (11) | (12) | (13) | (14) |
|---|---|---|---|---|---|---|---|---|---|---|---|---|---|---|---|
| EGMAVA-Modified Composition 1 | Part(s) by Mass | 10 | 10 | 10 | 10 | 10 | 10 | 10 | 10 | 10 | 10 | - | - | - | - |
| EGMAVA-Modified Composition 2 | Part(s) by Mass | - | - | - | - | - | - | - | - | - | - | - | 10 | - | - |
| EGMAVA-Modified Composition 3 | Part(s) by Mass | - | - | - | - | - | - | - | - | - | - | - | - | 10 | - |
| EGMAVA-Modified Composition 4 | Part(s) by Mass | - | - | - | - | - | - | - | - | - | - | - | - | - | 10 |
| EVA1 | Part(s) by Mass | 90 | - | - | - | - | - | - | - | - | - | - | 90 | 90 | 90 |
| LDPE1 | Part(s) by Mass | - | 90 | - | - | - | - | - | - | - | - | - | - | - | - |
| LDPE2 | Part(s) by Mass | - | - | 90 | - | - | - | - | - | - | - | - | - | - | - |
| EMA1 | Part(s) by Mass | - | - | - | 90 | - | - | - | - | - | - | - | - | - | - |
| EEA1 | Part(s) by Mass | - | - | - | - | 90 | - | - | - | - | - | - | - | - | - |
| EBA1 | Part(s) by Mass | - | - | - | - | - | 90 | - | - | - | - | - | - | - | - |
| EC1 | Part(s) by Mass | - | - | - | - | - | - | 90 | - | - | - | - | - | - | - |
| EC2 | Part(s) by Mass | - | - | - | - | - | - | - | 90 | - | - | - | - | - | - |
| EC3 | Part(s) by Mass | - | - | - | - | - | - | - | - | 90 | - | - | - | - | - |
| EC4 | Part(s) by Mass | - | - | - | - | - | - | - | - | - | 90 | - | - | - | - |
| EVA2 | Part(s) by Mass | - | - | - | - | - | - | - | - | - | - | 100 | - | - | - |

**Table 2**

| | | Example 1 | Example 2 | Example 3 | Example 4 | Example 5 | Example 6 | Example 7 | Example 8 | Example 9 | Example 10 |
|---|---|---|---|---|---|---|---|---|---|---|---|
| Layer Configuration | Resin Composition Constituting Adhesive Layer | (1) | (4) | (5) | (6) | (7) | (8) | (9) | (12) | (13) | (14) |
| | Electrically Insulating Resin Film Layer | PET | PET | PET | PET | PET | PET | PET | PET | PET | PET |

| Adhesion Performance | | | | | | | | | | | |
|---|---|---|---|---|---|---|---|---|---|---|---|
| Initial | N/15 mm | 22 .7 | 28.2 | 21.0 | 30.6 | 21.1 | 25.3 | 12.5 | 21.7 | 26.2 | 25.2 |
| After 500 h (85°C, 90%RH) | N/15 mm | 19.9 | 27.8 | 24.3 | 28.5 | 33.1 | 28.3 | 20.5 | 19.3 | 17.8 | 19.2 |
| After 1000 h (85°C, 90%RH) | N/15 mm | 18.9 | 43.0 | 23.1 | 23.5 | 27.3 | 27.5 | 18.4 | 18.8 | 17.6 | 20.0 |

| Insulating Properties | | | | | | | | | | | |
|---|---|---|---|---|---|---|---|---|---|---|---|
| Breakdown Voltage | kV | 15.3 | 14.6 | 15.2 | 17.3 | 16.9 | 17.9 | 17.1 | 17.6 | 17 | 17.3 |

| Mechanical Properties | | | | | | | | | | | |
|---|---|---|---|---|---|---|---|---|---|---|---|
| Bending Rigidity (Adhesive Layer) | MPa | 72 | 15 | 37 | 34 | <10 | <10 | 120 | 35 | <10 | 39 |

**[Table 3]**

| | | Comparative Example 1 | Comparative Example 2 | Comparative Example 3 | Comparative Example 4 | Comparative Example 5 |
|---|---|---|---|---|---|---|
| Layer Configuration | Resin Composition Constituting Adhesive Layer | (2) | (3) | (10) | (11) | (1) |
| | Electrically Insulating Resin Film Layer | PET | PET | PET | PET | - |

| Adhesion Performance | | | | | | |
|---|---|---|---|---|---|---|
| Initial | N/15 mm | Not Bonded | Not Bonded | Not Bonded | 25.0 | Not Measured |
| After 500 h (80°C, 90%RH) | N/15 mm | | | | | |
| After 1000 h (80°C, 90%RH) | N/15 mm | | | | 4.0 | |

| Insulating Properties | | | | | | |
|---|---|---|---|---|---|---|
| Breakdown Voltage | kV | Not Measured | Not Measured | Not Measured | Not Measured | 13.0 |
| Mechanical Properties | | | | | | |
| Bending Rigidity (Adhesive layer) | MPa | 170 | 180 | 190 | 18 | 18 |

In the multilayer sheets according to Examples 1 to 10, a performance balance between adhesion performance, moisture resistance, flexibility, and insulating performance was good. On the other hand, in the sheets according to Comparative Examples 1 to 4, a performance balance between adhesion performance, moisture resistance, flexibility, and insulating performance was poor. In addition, the sheet according to Comparative Example 5 did not include the electrically insulating resin film layer. Therefore, insulating performance was insufficient, the rigidity of the sheet was weak, and thus handleability was poor.

## Claims

1. Use of an insulating multilayer sheet comprising:
an electrically insulating resin film layer; and
an adhesive layer that is provided on a single surface or both surfaces of the electrically insulating resin film layer,
wherein the adhesive layer includes an epoxy group-containing ethylene based copolymer (A) and at least one ethylene based copolymer (B) (excluding the epoxy group-containing ethylene based copolymer (A)) selected from the group consisting of an ethylene/polar monomer copolymer and an ethylene/α-olefin copolymer having a density of 920 kg/m³ or lower, and
wherein the insulating multilayer sheet is used for fixing a solar cell module to a fixing member and encapsulating an end portion of the solar cell module; or
wherein the insulating multilayer sheet is used for fixing a solar cell element and an encapsulating resin layer to each other and/or fixing solar cell elements to each other.

2. The use according to claim 1,
wherein a breakdown voltage measured according to JIS C 2110-1 under conditions of a temperature of 23±2°C, a humidity of 50±5% RH, and a pressure increase rate of 2.0 kV/sec is 12 kV or higher.

3. The use according to claim 1 or 2,
wherein the epoxy group-containing ethylene based copolymer (A) includes at least one selected from the group consisting of an ethylene/glycidyl (meth)acrylate copolymer, an ethylene/glycidyl (meth) acrylate/vinyl acetate copolymer, and an ethylene/glycidyl (meth)acrylate/(meth)acrylic acid ester copolymer.

4. The use according to any one of claims 1 to 3,
wherein the ethylene/polar monomer copolymer includes at least one selected from the group consisting of an ethylene/vinyl ester copolymer, an ethylene/unsaturated carboxylic acid ester copolymer, and an ethylene/unsaturated carboxylic acid copolymer.

5. The use according to any one of claims 1 to 4,
wherein at least a part of the epoxy group-containing ethylene based copolymer (A) and the ethylene based copolymer (B) in the adhesive layer is graft-modified by a silane coupling agent.

6. The use according to any one of claims 1 to 5,
wherein a content of the ethylene based copolymer (B) in the adhesive layer is 50 mass% or higher and 99 mass% or lower with respect to 100 mass% of a total amount of the epoxy group-containing ethylene based copolymer (A) and the ethylene based copolymer (B).

7. The use according to any one of claims 1 to 6,
wherein the electrically insulating resin film layer is formed of at least one resin selected from the group consisting of polyethylene terephthalate, polybutylene terephthalate, polymethyl (meth)acrylate, and fluorine-based resin.

8. A solar cell module comprising:
a substrate on which sunlight is incident;
a solar cell element;
a back sheet;
an encapsulating resin layer that encapsulates the solar cell element between the substrate and the back sheet; and
an insulating multilayer sheet comprising:
an electrically insulating resin film layer; and
an adhesive layer that is provided on a single surface or both surfaces of the electrically insulating resin film layer,
wherein the adhesive layer includes an epoxy group-containing ethylene based copolymer (A) and at least one ethylene based copolymer (B) (excluding the epoxy group-containing ethylene based copolymer (A)) selected from the group consisting of an ethylene/polar monomer copolymer and an ethylene/α-olefin copolymer having a density of 920 kg/m³ or lower, and
wherein the insulating multilayer sheet encapsulates an end portion of the solar cell module and fixes the solar cell module to a fixing member; or
wherein the insulating multilayer sheet fixes the solar cell element and the encapsulating resin layer to each other and/or fixes the solar cell elements to each other.

9. The solar cell module according to claim 8,
wherein a breakdown voltage measured according to JIS C 2110-1 under conditions of a temperature of 23±2°C, a humidity of 50±5% RH, and a pressure increase rate of 2.0 kV/sec is 12 kV or higher.

10. The solar cell module according to any one of claims 8 or 9,
wherein the epoxy group-containing ethylene based copolymer (A) includes at least one selected from the group consisting of an ethylene/glycidyl (meth)acrylate copolymer, an ethylene/glycidyl (meth) acrylate/vinyl acetate copolymer, and an ethylene/glycidyl (meth)acrylate/(meth)acrylic acid ester copolymer.

11. The solar cell module according to any one of claims 8 to 10,
wherein the ethylene/polar monomer copolymer includes at least one selected from the group consisting of an ethylene/vinyl ester copolymer, an ethylene/unsaturated carboxylic acid ester copolymer, and an ethylene/unsaturated carboxylic acid copolymer.

12. The solar cell module according to any one of claims 8 to 11,
wherein at least a part of the epoxy group-containing ethylene based copolymer (A) and the ethylene based copolymer (B) in the adhesive layer is graft-modified by a silane coupling agent.

13. The solar cell module according to any one of claims 8 to 12,
wherein a content of the ethylene based copolymer (B) in the adhesive layer is 50 mass% or higher and 99 mass% or lower with respect to 100 mass% of a total amount of the epoxy group-containing ethylene based copolymer (A) and the ethylene based copolymer (B).

14. The solar cell module according to any one of claims 8 to 13,
wherein the electrically insulating resin film layer is formed of at least one resin selected from the group consisting of polyethylene terephthalate, polybutylene terephthalate, polymethyl (meth)acrylate, and fluorine-based resin.

## Patentansprüche

1. Verwendung einer isolierenden Mehrschichtfolie, umfassend:
eine elektrisch isolierende Harzfilmschicht; und
eine Haftschicht, die auf einer einzigen Oberfläche oder beiden Oberflächen der elektrisch isolierenden Harzfilmschicht vorgesehen ist,
wobei die Haftschicht ein Epoxygruppen enthaltendes Copolymer auf Ethylenbasis (A) und mindestens ein Copolymer auf Ethylenbasis (B) (mit Ausnahme des Epoxygruppen enthaltenden Copolymers auf Ethylenbasis (A)), ausgewählt aus der Gruppe bestehend aus einem Ethylen/polares Monomer-Copolymer und einem Ethylen/α-Olefin-Copolymer, das eine Dichte von 920 kg/m³ oder kleiner aufweist, umfasst, und
wobei die isolierende Mehrschichtfolie zum Befestigen eines Solarzellenmoduls an einem Befestigungselement und Verkapseln eines Endteils des Solarzellenmoduls verwendet wird; oder
wobei die isolierende Mehrschichtfolie zum Befestigen eines Solarzellenelements und einer verkapselnden Harzschicht aneinander und/oder Befestigen von Solarzellenelementen aneinander verwendet wird.

2. Verwendung nach Anspruch 1,
wobei eine Durchschlagspannung 12 kV oder höher ist, gemessen gemäß JIS C 2110-1 unter Bedingungen einer Temperatur von 23 ± 2 °C, einer Luftfeuchtigkeit von 50 ± 5 % RH und einer Druckerhöhungsrate von 2,0 kV/s.

3. Verwendung nach Anspruch 1 oder 2,
wobei das Epoxygruppen enthaltende Copolymer auf Ethylenbasis (A) mindestens eines umfasst, das ausgewählt ist aus der Gruppe bestehend aus einem Ethylen/Glycidyl(meth)acrylat-Copolymer, einem Ethylen/Glycidyl(meth)acrylat/Vinylacetat-Copolymer und einem Ethylen/Glycidyl(meth)acrylat/(Meth)acrylsäureester-Copolymer.

4. Verwendung nach einem der Ansprüche 1 bis 3,
wobei das Ethylen/polares Monomer-Copolymer mindestens eines umfasst, das ausgewählt ist aus der Gruppe bestehend aus einem Ethylen/Vinylester-Copolymer, einem Ethylen/ungesättigter Carbonsäureester-Copolymer und einem Ethylen/ungesättigte Carbonsäure-Copolymer.

5. Verwendung nach einem der Ansprüche 1 bis 4,
wobei zumindest ein Teil des Epoxygruppen enthaltenden Copolymers auf Ethylenbasis (A) und des Copolymers auf Ethylenbasis (B) in der Haftschicht mit einem Silan-Kupplungsmittel pfropfmodifiziert ist.

6. Verwendung nach einem der Ansprüche 1 bis 5,
wobei ein Gehalt an dem Copolymer auf Ethylenbasis (B) in der Haftschicht 50 Masse-% oder höher und 99 Masse-% oder niedriger in Bezug auf 100 Masse-% einer Gesamtmenge des Epoxygruppen enthaltenden Copolymers auf Ethylenbasis (A) und des Copolymers auf Ethylenbasis (B) ist.

7. Verwendung nach einem der Ansprüche 1 bis 6,
wobei die elektrisch isolierende Harzfilmschicht aus mindestens einem Harz gebildet ist, das ausgewählt ist aus der Gruppe bestehend aus Polyethylenterephthalat, Polybutylenterephthalat, Polymethyl(meth)acrylat und Harz auf Fluorbasis.

8. Solarzellenmodul, umfassend:
ein Substrat, auf das Sonnenlicht auftrifft;
ein Solarzellenelement;
eine Rückseitenfolie;
eine verkapselnde Harzschicht, die das Solarzellenelement zwischen dem Substrat und der Rückseitenfolie verkapselt; und
eine isolierende Mehrschichtfolie, umfassend:
eine elektrisch isolierende Harzfilmschicht; und
eine Haftschicht, die auf einer einzigen Oberfläche oder beiden Oberflächen der elektrisch isolierenden Harzfilmschicht vorgesehen ist,
wobei die Haftschicht ein Epoxygruppen enthaltendes Copolymer auf Ethylenbasis (A) und mindestens ein Copolymer auf Ethylenbasis (B) (mit Ausnahme des Epoxygruppen enthaltenden Copolymers auf Ethylenbasis (A)), ausgewählt aus der Gruppe bestehend aus einem Ethylen/polares Monomer-Copolymer und einem Ethylen/α-Olefin-Copolymer, das eine Dichte von 920 kg/m³ oder kleiner aufweist, umfasst, und
wobei die isolierende Mehrschichtfolie einen Endteil des Solarzellenmoduls verkapselt und das Solarzellenmodul an einem Befestigungselement befestigt; oder
wobei die isolierende Mehrschichtfolie das Solarzellenelement und die verkapselnde Harzschicht aneinander befestigt und/oder die Solarzellenelemente aneinander befestigt.

9. Solarzellenmodul nach Anspruch 8,
wobei eine Durchschlagspannung 12 kV oder höher ist, gemessen gemäß JIS C 2110-1 unter Bedingungen einer Temperatur von 23 ± 2 °C, einer Luftfeuchtigkeit von 50 ± 5 % RH und einer Druckerhöhungsrate von 2,0 kV/s.

10. Solarzellenmodul nach einem der Ansprüche 8 oder 9,
wobei das Epoxygruppen enthaltende Copolymer auf Ethylenbasis (A) mindestens eines umfasst,das ausgewählt ist aus der Gruppe bestehend aus einem Ethylen/Glycidyl(meth)acrylat-Copolymer, einem Ethylen/Glycidyl(meth)acrylat/Vinylacetat-Copolymer und einem Ethylen/Glycidyl(meth)acrylat/(Meth)acrylsäureester-Copolymer.

11. Solarzellenmodul nach einem der Ansprüche 8 bis 10,
wobei das Ethylen/polares Monomer-Copolymer mindestens eines umfasst, das ausgewählt ist aus der Gruppe bestehend aus einem Ethylen/Vinylester-Copolymer, einem Ethylen/ungesättigter Carbonsäureester-Copolymer und einem Ethylen/ungesättigte Carbonsäure-Copolymer.

12. Solarzellenmodul nach einem der Ansprüche 8 bis 11,
wobei zumindest ein Teil des Epoxygruppen enthaltenden Copolymers auf Ethylenbasis (A) und des Copolymers auf Ethylenbasis (B) in der Haftschicht mit einem Silan-Kupplungsmittel pfropfmodifiziert ist.

13. Solarzellenmodul nach einem der Ansprüche 8 bis 12,
wobei ein Gehalt an dem Copolymer auf Ethylenbasis (B) in der Haftschicht 50 Masse-% oder höher und 99 Masse-% oder niedriger in Bezug auf 100 Masse-% einer Gesamtmenge des Epoxygruppen enthaltenden Copolymers auf Ethylenbasis (A) und des Copolymers auf Ethylenbasis (B) ist.

14. Solarzellenmodul nach einem der Ansprüche 8 bis 13,
wobei die elektrisch isolierende Harzfilmschicht aus mindestens einem Harz gebildet ist, das ausgewählt ist aus der Gruppe bestehend aus Polyethylenterephthalat, Polybutylenterephthalat, Polymethyl(meth)acrylat und Harz auf Fluorbasis.

## Revendications

1. Utilisation d'une feuille multicouche isolante comprenant :
une couche d'un film d'une résine électriquement isolante ; et
une couche adhésive qui est fournie sur une seule surface ou sur les deux surfaces de la couche du film de résine électriquement isolante,
la couche adhésive incluant un copolymère à base d'éthylène contenant un groupement époxy (A) et au moins un copolymère à base d'éthylène (B) [autre que le copolymère à base d'éthylène contenant un groupement époxy (A)] sélectionné dans le groupe consistant en un copolymère éthylène/monomère polaire et un copolymère éthylène/α-oléfine ayant une masse volumique inférieure ou égale à 920 kg/m³, et
la feuille multicouche isolante étant utilisée pour fixer un module de cellule solaire à un organe de fixation et pour encapsuler une portion d'extrémité du module de cellule solaire ; ou
la feuille multicouche isolante étant utilisée pour fixer un élément d'une cellule solaire et une couche d'une résine d'encapsulation l'un avec l'autre et/ou pour fixer des éléments d'une cellule solaire les uns avec les autres.

2. Utilisation selon la revendication 1,
une tension de rupture étant égale ou supérieure à 12 kV, mesurée conformément à la norme JIS C 2110-1 dans les conditions suivantes : température de 23 ± 2 °C, humidité relative de 50 ± 5 % et gradient d'augmentation de la pression de 2,0 kV/s.

3. Utilisation selon la revendication 1 ou 2,
le copolymère à base d'éthylène contenant un groupement époxy (A) incluant un au moins sélectionné dans le groupe consistant en un copolymère éthylène/(méth)acrylate de glycidyle, un copolymère éthylène/(méth)acrylate de glycidyle/acétate de vinyle et un copolymère éthylène/(méth)acrylate de glycidyle/ester d'un acide (méth)acrylique.

4. Utilisation selon l'une quelconque des revendications 1 à 3,
le copolymère éthylène/monomère polaire incluant un au moins sélectionné dans le groupe consistant en un copolymère éthylène/ester vinylique, un copolymère éthylène/ester d'un acide carboxylique insaturé et un copolymère éthylène/acide carboxylique insaturé.

5. Utilisation selon l'une quelconque des revendications 1 à 4,
au moins une partie du copolymère à base d'éthylène contenant un groupement époxy (A) et du copolymère à base d'éthylène (B) dans la couche adhésive étant modifiée par greffage d'un agent de couplage de type silane.

6. Utilisation selon l'une quelconque des revendications 1 à 5,
une teneur en le copolymère à base d'éthylène (B) dans la couche adhésive représentant 50 % en masse ou plus et 99 % en masse ou moins, rapportée à 100 % en masse d'une quantité totale du copolymère à base d'éthylène contenant un groupement époxy (A) et du copolymère à base d'éthylène (B).

7. Utilisation selon l'une quelconque des revendications 1 à 6,
la couche du film de résine électriquement isolante étant constituée de l'une au moins résine sélectionnée dans le groupe consistant en un poly(téréphtalate d'éthylène), un poly(téréphtalate de butylène), un poly((méth)acrylate de méthyle) et une résine à base de fluor.

8. Module de cellule solaire comprenant :
un substrat sur lequel la lumière du soleil est incidente ;
un élément de cellule solaire ;
une feuille arrière ;
une couche d'une résine d'encapsulation qui encapsule l'élément de cellule solaire entre le substrat et la feuille arrière ; et
une feuille multicouches isolante comprenant :
une couche d'un film d'une résine électriquement isolante ; et
une couche adhésive qui est fournie sur une seule surface ou sur les deux surfaces de la couche du film de résine électriquement isolante,
la couche adhésive incluant un copolymère à base d'éthylène contenant un groupement époxy (A) et au moins un copolymère à base d'éthylène (B) [autre que le copolymère à base d'éthylène contenant un groupement époxy (A)] sélectionné dans le groupe consistant en un copolymère éthylène/monomère polaire et un copolymère éthylène/α-oléfine ayant une masse volumique inférieure ou égale à 920 kg/m³ et
la feuille multicouche isolante encapsulant une portion d'extrémité du module de cellule solaire et fixe le module de cellule solaire à un organe de fixation ; ou
la feuille multicouche isolante fixant un élément d'une cellule solaire et la couche d'une résine d'encapsulation l'un avec l'autre et/ou fixe des éléments d'une cellule solaire les uns avec les autres.

9. Module de cellule solaire selon la revendication 8,
une tension de rupture étant égale ou supérieure à 12 kV, mesurée conformément à la norme JIS C 2110-1 dans les conditions suivantes : température de 23 ± 2 °C, humidité relative de 50 ± 5 % et gradient d'augmentation de la pression de 2,0 kV/s.

10. Module de cellule solaire selon l'une quelconque des revendications 8 ou 9,
le copolymère à base d'éthylène contenant un groupement époxy (A) incluant un au moins sélectionné dans le groupe consistant en un copolymère éthylène/(méth)acrylate de glycidyle, un copolymère éthylène/(méth)acrylate de glycidyle/acétate de vinyle et un copolymère éthylène/(méth)acrylate de glycidyle/ester d'un acide (méth)acrylique.

11. Module de cellule solaire selon l'une quelconque des revendications 8 à 10,
le copolymère éthylène/monomère polaire incluant un au moins sélectionné dans le groupe consistant en un copolymère éthylène/ester vinylique, un copolymère éthylène/ester d'un acide carboxylique insaturé et un copolymère éthylène/acide carboxylique insaturé.

12. Module de cellule solaire selon l'une quelconque des revendications 8 à 11,
au moins une partie du copolymère à base d'éthylène contenant un groupement époxy (A) et du copolymère à base d'éthylène (B) dans la couche adhésive étant modifiée par greffage d'un agent de couplage de type silane.

13. Module de cellule solaire selon l'une quelconque des revendications 8 à 12,
une teneur en le copolymère à base d'éthylène (B) dans la couche adhésive représentant 50 % en masse ou plus et 99 % en masse ou moins, rapportée à 100 % en masse d'une quantité totale du copolymère à base d'éthylène contenant un groupement époxy (A) et du copolymère à base d'éthylène (B).

14. Module de cellule solaire selon l'une quelconque des revendications 8 à 13,
la couche du film de résine électriquement isolante étant constituée de l'une au moins résine sélectionnée dans le groupe consistant en un poly(téréphtalate d'éthylène), un poly(téréphtalate de butylène), un poly((méth)acrylate de méthyle) et une résine à base de fluor.
